(19) Europäisches Patentamt
European Patent Office
Office européen des brevets

(11) EP 0 641 826 B1

(12) **EUROPÄISCHE PATENTSCHRIFT**

(45) Veröffentlichungstag und Bekanntmachung des Hinweises auf die Patenterteilung:
**14.04.2004 Patentblatt 2004/16**

(51) Int Cl.[7]: **C08L 63/00**, C08G 59/38, C08L 83/06, H01B 3/40

(21) Anmeldenummer: **94111946.3**

(22) Anmeldetag: **29.07.1994**

(54) **Siloxanhaltiges Giessharzsystem**

Siloxane comprising casting resin composition

Composition de résine à couler contenant du siloxane

(84) Benannte Vertragsstaaten:
**CH DE ES FR GB IT LI**

(30) Priorität: **24.08.1993 DE 4328466**

(43) Veröffentlichungstag der Anmeldung:
**08.03.1995 Patentblatt 1995/10**

(73) Patentinhaber: **Infineon Technologies AG**
**81669 München (DE)**

(72) Erfinder:
- **Höhn, Klaus**
  **D-82024 Taufkirchen (DE)**
- **Waitl, Günther**
  **D-93049 Regensburg (DE)**
- **Reeh, Ulrike**
  **D-80995 München (DE)**
- **Wipfelder, Ernst**
  **D-81673 München (DE)**

(74) Vertreter: **Epping, Hermann, Fischer**
**Patentanwaltsgesellschaft mbH**
**Ridlerstrasse 55**
**80339 München (DE)**

(56) Entgegenhaltungen:
**EP-A- 0 567 079**
**US-A- 3 284 398**
**US-A- 3 839 280**

EP 0 641 826 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

Printed by Jouve, 75001 PARIS (FR)

## Beschreibung

Für SMT-fähige optoelektronische Bauelemente, beispielsweise für optoelektronische Multichiparrays, werden temperatur- und farbstabile Gießharze zur Abdeckung gefordert.

Transparente farbstabile Gießharze sind beispielsweise aus der DE 26 42 465 bekannt. Sie werden bevorzugt eingesetzt zur Umhüllung von LEDs und SMT-fähigen LEDs, sogenannten TOPLEDs. Für die Abdeckung großflächiger Bauelemente, wie zum Beispiel zur Abdeckung der oben angeführten Multichiparrays sind diese Harze nur bedingt geeignet. Großflächige Abdeckungen aus den bekannten Harzen weisen Risse und Haftungsprobleme auf, die insbesondere nach Temperaturschockbehandlung oder nach der zum Anlöten erforderlichen Löthitze auftreten. Diese können die optischen und/oder elektrischen Eigenschaften der optoelektronischen Bauelemente beeinträchtigen.

Aufgabe der vorliegenden Erfindung ist es daher, ein zur Abdeckung von optoelektronischen Bauelementen geeignetes Gießharz anzugeben, mit welchem sich eine temperatur- und auch über eine längere Lebensdauer farbstabile Abdeckung erzeugen läßt, und welches die Nachteile der für optoelektronische Bauelemente bekannten Gießharze vermeidet. Insbesondere soll der Formstoff hohen Dauerbetriebstemperaturen von 125°C sowie der Temperaturbelastung beim Lötprozeß widerstehen.

Diese Aufgabe wird erfindungsgemäß gelöst durch ein Gießharzsystem nach Anspruch 1. Weitere Ausgestaltungen der Erfindung, insbesondere ein Verfahren zur Herstellung des Gießharzsystems und eine bevorzugte Verwendung sind den Unteransprüchen zu entnehmen.

Überraschend wurde gefunden, daß die erfindungsgemäßen mit Siloxan modifizierten Epoxidharzsysteme das obengenannte Problem in hervorragender Weise lösen. Die Gießharze, bzw. deren A-Komponenten sind wasserklar und transparent. Sie lassen sich ohne wesentliche Erhöhung ihrer Viskosität bzw. ohne Verminderung des Epoxidgehalts mehrere Monate bei Raumtemperatur lagern und wie herkömmliche Epoxidgießharze verarbeiten. Die Chemie bzw. die Reaktivität des Epoxidharzes wird durch durch die Epoxyalkoxysiloxane nicht nachteilig beeinflußt.

Polyepoxidpolysiloxanverbindungen und deren Verwendung für härtbare Mischungen sind beispielsweise aus der DE-OS 2 251 953 bekannt.

Verschiedene epoxidgruppenhaltige Siloxane sind aus Chemical Abstracts 1992, Bd. 116, Ref. 42881g der JP 03-192151 (2), Central Patents Index, 1989, Ref. 89-066577/09 der JP 01-020226 (3), Central Patents Index, 1992, Ref. 92-029776/04 der JP-03-277619 (4) und Chemical Abstracts 1993, Bd. 119, Ref. 50634 f der JP-04-331254 (5) bekannt.

Die aus dem erfindungsgemäßen Gießharzsystem durch Härtung erhaltbaren Formstoffe sind durch den Zusatz des Epoxyalkoxysiloxans im Vergleich zu den siloxanfreien Formstoffen zwar flexibilisiert, zeigen jedoch nicht die üblicherweise damit verbundenen Nachteile. So ist die Glasübergangstemperatur der Formstoffe nur unwesentlich geringer als die eines siloxanfreien Vergleichsharzes. Auch der E-Modul bleibt hoch, während das elastische Verhalten verbessert ist. Verbessert ist die thermische Beständigkeit, die sich insbesondere in einer niedrigeren thermischen Abbaurate und in einer höheren Zersetzungstemperatur äußert. Dabei sind die Formstoffe klar und transparent. Im verschärften Alterungsprozeß zeigen sie eine hohe Farbstabilität und erfüllen die geforderten Spezifikationen.

Ein besonders vorteilhaftes Gießharzsystem wird erhalten, wenn das in der A-Komponente zu 5 bis 95 Gewichtsprozent enthaltene Epoxyalkylsiloxan durch Kondensation eines Epoxyalkoxysilans 1 mit einem Silanol 2 hergestellt wird,

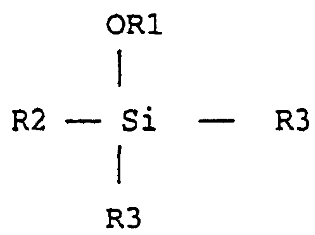

1

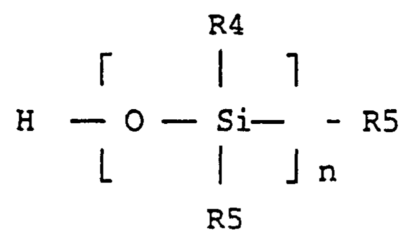

2

R1 für einen Alkylrest mit 1 bis 6 C-Atomen oder einen Arylrest steht,
R2 ein, Epoxyalkyl oder ein Epoxycycloalkylrest ist, die beiden Reste
R3 unabhängig voneinander für OR1 oder R2 oder einen weiteren Alkyl- bzw. Arylrest stehen,
R4 Alkyl oder Aryl bedeutet, die Reste

R5 unabhängig voneinander für OH oder R4 stehen und
n eine ganze Zahl mit $1 \leq n \leq 12$ ist.

Diese Umsetzung läßt sich in einer einfachen Eintopfreaktion unter Normalbedingungen bezüglich Atmosphäre und Druck und mit minimalem Verfahrensaufwand zu reproduzierbaren Siloxankondensationsprodukten in kürzester Zeit durchführen. Die Primärprodukte sind mit kommerziell erhältlichen Epoxiden gut verträglich und in jedem Verhältnis gut mischbar. Derartige Mischungen sind lagerstabil und mit den für die Gießharztechnologie gebräuchlichen Carbonsäureanhydriden vernetzbar.

Das Epoxyalkoxysilan 1 trägt 1 bis 3 kondensationsfähige Alkoxygruppen. Der Rest R1 ist beliebig, vorzugsweise jedoch ein Alkylrest mit 1 bis 6 C-Atomen, da die Reaktivität der bei der Kondensation abzuspaltenden Gruppe mit zunehmender Kettenlänge des Alkylrestes abnimmt. Reaktivste Ausgangsverbindungen sind also Epoxymethoxysilane 1. Da bei der Kondensation Alkohol abgespalten wird, kann wegen der Unbedenklichkeit von Ethylalkohol auch Ethyl als Alkylgruppe R1 bevorzugt sein.

Wegen ihrer einfacheren Verfügbarkeit sind monomere Epoxyalkoxysilane 1 bevorzugt, doch ist die Reaktion prinzipiell auch mit entsprechend längerkettigen Alkoxysiloxanen möglich.

Einfacher verfügbar und auch preisgünstiger sind längerkettige Silanole 2, die die OH-Gruppen in Alphastellung, Alphaund

Omega-Stellung oder in der Kette aufweisen. Die über SiC gebundene weitere organische Gruppe R4 ist bezüglich ihrer Auswahl unkritisch und kann ein beliebiger Alkyl- oder Arylrest sein. Der Index n, der die Anzahl der Siloxaneinheiten bestimmt, kann zwischen 1 und 12 frei gewählt werden. In Abhängigkeit von den übrigen Resten kann sich jedoch mit zunehmender Kettenlänge eine zunehmende Unverträglichkeit der Kondensationsprodukte (Epoxyalkylsiloxane) ergeben, die deren Verwendung im erfindungsgemäßen Gießharzsystem erschweren oder unmöglich machen können.

Der epoxidgruppenhaltige Rest R2 der Ausgangsverbindung 1 ist über ein C-Atom an Silizium gebunden. Je nach Verfügbarkeit des entsprechenden Epoxyalkoxysilans kann R2 eine Epoxyalkyl- oder Epoxycycloalkylgruppe sein.

Je nach Reaktivität der Ausgangsstoffe, welche elektronisch und sterisch gehindert sein können, kann zur Unterstützung der Umsetzung ein Kondensationskatalysator erforderlich sein. Im Hinblick auf die Umsetzung selbst ergeben sich für den Katalysator keine Einschränkungen, so daß ein beliebiger Kondensationskatalysator geeignet ist. Voraussetzung ist jedoch, daß der Katalysator die Epoxidgruppe nicht beeinflußt und das Lagerverhalten sowie den Härtungsprozeß des Gießharzsystems ebenfalls nicht beeinträchtigt. Ein idealer Katalysator reagiert daher weder ausgesprochen basisch noch ausgesprochen sauer, im Idealfall neutral.

Die Umsetzung der Ausgangsstoffe 1 und 2 kann in Lösung oder als Bulkreaktion durchgeführt werden.

Bevorzugte Umsetzungstemperaturen liegen zwischen 80 und 150°C, wobei in einem offenen Reaktionsgefäß flüchtige Reaktionsprodukte vorzugsweise durch Einleiten eines Inertgasstromes ausgeblasen werden. Dadurch werden Haltbarkeit und Stabilität sowohl des Epoxyalkylsiloxans als auch des Gießharzsystems erhöht. Durch Erhitzen der A-Komponente in einem angelegten Vakuum kann die Lagerstabilität des Gießharzsystems gesteigert werden.

Die Kondensation von 1 und 2 wird vorzugsweise annähernd stöchiometrisch durchgeführt, so daß bei beiden Reaktionspartnern annähernd dieselbe Zahl kondensationsfähiger Gruppen, also Hydroxidgruppen beim Silanol 2 und Alkoxygruppen bei 1, zur Verfügung stehen.

Im folgenden wird das Verfahren zur Herstellung des erfindungsgemäßen Gießharzsystems anhand von Ausführungsbeispielen näher beschrieben.

Herstellung der siloxanmodifzierten A-Komponente:

Als Alkoxysilan 1 wird das bereits als Haftvermittler für Epoxidharze bekannte 3-Glycidylpropyltrimethoxysilan (GPT) hergenommen, welches in Anteilen von ca. 0,25 Prozent üblichen Epoxidharzen beigemischt wird. Als Silanol 2 wird $\alpha$, $\bar{\omega}$-Propylphenylsilandiol (PPS) ausgewählt. 11,8 gr GPT (50 mMol) werden bei 120°C portionsweise innerhalb von 15 Minuten mit 57,8 gr PPS versetzt. Die Silanolmenge ist so bemessen, daß den Methoxyfunktionen äquivalente Mengen an OH-Gruppen zur Kondensation zur Verfügung stehen. Unter Methanolentwicklung löst sich das feste PPS auf, es bildet sich hochviskoses Siloxankondensat. Dabei wird das Reaktionsgemisch insgesamt 4 Stunden bei 120°C unter gleichzeitigem Abdestillieren von Methanol sowie Überleiten von Stickstoff gerührt. Dieses methanolhaltige Kondensat enthält unterschiedliche Siloxanprodukte und wird direkt bei 120°C mit der gewünschten Menge an Epoxidgießharz zu einer lagerfähigen siloxanhaltigen A-Komponente verarbeitet.

Dazu wird ein wie oben hergestelltes Epoxyalkylsiloxan (Siloxankondensat) in unterschiedlichem Mischungsverhältnis mit cycloaliphatischem Epoxid CY 179 (3, 4-Epoxycyclohexylmethyl-3', 4'-epoxycyclohexan carboxylat, Ciba-Geigy) vermischt.

Beispielsweise ändert sich die Viskosität bei 60°C sowie der Epoxidwert einer A-Komponente, bestehend

aus vier Teilen Siloxankondensat und einem Teil CY 179 nach einer Lagerung von 6 Monaten bei 60°C nur geringfügig. Dabei steigt die Viskosität von 120 auf 160 mPas und der Epoxidwert sinkt von 0,581 auf 0,574 mol/100 g ab.

Die folgende Tabelle gibt einige Eigenschaften der Mischungen V1 bis V4 an, die dem bekannten reinen cycloaliphatischen Epoxid im Versuch VO gegenübergestellt werden.

Kenndaten der A-Komponenten

| | V0 | V1 | V2 | V3 | V4 |
|---|---|---|---|---|---|
| Epoxidwert (mol/100g) | 0,73 | 0,58 | 0,39 | 0,26 | 0,20 |
| Kondensatanteil (%) | 0 | 20 | 50 | 70 | 80 |
| Viskosität η (60°C) (mPas) | 40 | 120 | 240 | 5.800 | 7.000 |
| $n_D$ (20°C) | 1,498 | 1,505 | 1,513 | 1,518 | 1,519 |
| Farbe | wasserklar, transparent | wasserklar, transparent | wasserklar, transparent | wasserklar, transparent | wasserklar, transparent |

Herstellung eines transparenten Formstoffes

Der Gehalt an cycloaliphatischem Epoxid bestimmt die Viskosität und den Epoxidwert und somit die Verarbeitbarkeit der durch Mischen hergestellten A-Komponente, die entsprechend ihrem Epoxidgehalt mit einer stöchiometrischen Menge an B-Komponente versetzt wird. Diese enthält ein Carbonsäureanhydrid, welches teilweise mit einem Alkylalkohol verestert sein kann. Geeignete Anhydride sind beispielsweise (Methyl-) Tetrahydrophthalsäureanhydrid oder (Methyl-) Hexahydrophthalsäureanhydrid. Für das Ausführungsbeispiel wird Hexahydrophthalsäureanhydrid ausgewählt, welches pro 100 Gewichtteilen mit 13 Gewichtsteilen des entsprechenden Monoethylesters vermischt ist. Als Beschleuniger wird dem Gießharzsystem ein Metallkomplexkatalysator zugesetzt, beispielsweise Zinkoctoat. In geringen Anteilen können außerdem weitere, für Gießharze übliche Zusätze zugemischt werden. Weitere mögliche Beschleuniger sind beispielsweise farblose Metallchelatverbindungen, insbesondere des Al, Zn oder Zr mit Anionen organischer Säuren, zum Beispiel mit Acetat, Acrylat, Benzoat, Salicylat, Octoat oder Acetylacetonat.
Die Aushärtung wird beispielsweise bei 150°C durchgeführt und ist nach vier Stunden vollständig beendet.
Die höhere thermische Beständigkeit dieser Formstoffe wird durch TG/DTA-Experimente bis 800°C bestätigt. Dabei wird ein zweistufiger Abbaumechanismus beobachtet. Mit steigendem Siloxangehalt nimmt die Abbaurate ab und der jeweilige Pyrolyse- sowie der Verbrennungsrückstand zu.
Die Formstoffe sind klar und transparent und bestehen sämtlich den Lötbadtest (3 x Erhitzen auf 260°C für jeweils 5 Sekunden).
Anhand massiver gehärteter Formstoffteile werden Glasübergangstemperaturen $T_g$ und E-Module bestimmt:
Einfluß des Siloxananteils auf $T_g$ und E-Modul:

| | V0 | V1 | V2 | V4 |
|---|---|---|---|---|
| Kondensatanteil (%) | 0 | 20 | 50 | 80 |
| E-Modul (20°C) (N/mmH2) | 2.800 | 2.750 | 2.500 | 2.200 |
| $T_g$ ($\tan\delta_{max}$) (°C) | 177 | 170 | 153 | 99 |
| $\tan\delta(T_g)$ | 0,976 | 0,855 | 0,654 | 0,601 |

Die Wasseraufnahme (7 Tage bei 23°C) ist für sämtliche erfindungsgemäß hergestellte Formstoffe gegenüber V0 verringert.
Ein mit dem erfindungsgemäßen Gießharz abgedecktes Multichiparray wird bei Betriebstemperaturen von 125°C getestet, zwischendurch 100 Temperaturzyklen von - 55 bis + 125°C und schließlich zweimal den Lötbedingungen von je 5 Sekunden lang Erhitzen auf 260°C unterworfen. In der Abdeckung treten keinerlei Risse oder sonstige Veränderungen auf. Das Bauelement ist in seinen elektrischen und optischen Eigenschaften unbeeinträchtigt.
Die positiven Eigenschaften des erfindungsgemäßen Gießharzsystems werden dabei nicht nur mit dem beispielhaft angegebenen Ausführungsbeispiel erzielt, sondern auch mit beiliebigen Siloxankondensaten sowie mit beliebigen Epoxiden. Mit aliphatischen und aromatischen Glycidylethern, insbesondere auf der Basis von Bisphenol-A und -F, mit entsprechenden Glycidylestern, aliphatischen und cycloaliphatischen Epoxiden oder beliebigen anderen, beispielsweise durch Epoxidierung ungesättigter Verbindungen erhaltenen Epoxiden können geeignete Gießharzsystem zusammengemischt werden.
Mit entsprechenden Farbstoffen angefärbte Formstoffe zeigen auch nach Monaten noch keinerlei Farbveränderung.

**Patentansprüche**

1. Siloxanhaltiges Gießharzsystem, welches eine Harzkomponente A und zumindest ein Carbonsäureanhydrid als Härterkomponente B umfaßt, dessen A-Komponente
   5 bis 95 Gewichtsprozent Epoxyalkylsiloxan und
   95 bis 5 Gewichtsprozent Epoxid enthält,
   bei dem das Epoxyalkylsiloxan erhalten worden ist durch Umsetzen des Epoxyalkoxysilans (1) mit dem Silanol (2)

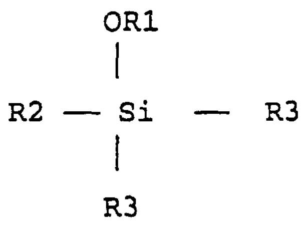

1

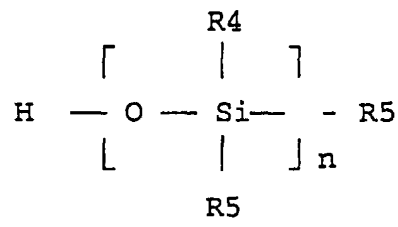

2

bei dem

R1 für einen Alkylrest mit 1 bis 6 C-Atomen oder einen Arylrest steht,
R2 ein Epoxyalkyl oder ein Epoxycycloalkylrest ist, die beiden Reste
R3 unabhängig voneinander für OR1 oder R2 oder einen weiteren Alkyl- bzw. Arylrest stehen,
R4 Alkyl oder Aryl bedeutet, die Reste
R5 unabhängig voneinander für OH oder R4 stehen und
n eine ganze Zahl mit $1 \leq n \leq 12$ ist.

**2.** Gießharzsystem nach Anspruch 1,
bei dem die B-Komponente Anhydride von aromatischen und cycloaliphatischen Di- und Tetracarbonsäuren enthält.

**3.** Gießharzsystem nach Anspruch 1 oder 2,
bei dem die B-Komponente zur Flexibilisierung ein zumindest teilweise mit Alkoholen verestertes Carbonsäureanhydrid enthält.

**4.** Verfahren zur Herstellung eines siloxanhaltigen Gießharzsystems mit folgenden Schritten:

a) Umsetzen des Epoxyalkoxysilans 1 mit dem Silanol 2, wobei ein Epoxysiloxan erhalten wird,

b) Vermischen des Epoxysiloxans mit einem cycloaliphatischen oder aromatischen Epoxid im Gewichtsverhältnis 1 : 20 bis 20 : 1,

c) Vorsehen einer Carbonsäureanhydrid enthaltenden B-Komponente.

**5.** Verfahren nach Anspruch 4,
bei dem Schritt a) unter Anwesenheit eines neutralen Kondensationskatalysators im Bereich pH 5 bis pH 8 durchgeführt wird.

**6.** Verfahren nach Anspruch 4 oder 5,
bei dem das Gießharzsystem nach Schritt b) einer Temperaturbehandlung im Vakuum unterzogen wird.

**7.** Verfahren nach einem der Ansprüche 4 bis 6,
bei dem die Umsetzung gemäß Schritt a) stöchiometrisch durchgeführt wird, so daß pro kondensationsfähiger OH-Gruppe bei 2 eine Alkoxygruppe bei 1 zur Verfügung steht.

**8.** Verfahren nach einem der Ansprüche 4 bis 7,
bei dem als Alkoxysilan 1 3-Glycidylpropyltrimethoxysilan und als Silanol 2 $\alpha,\omega$-Propylphenylsilandiol miteinander umgesetzt wird.

**9.** Verwendung des Gießharzsystems nach einem der vorangehenden Ansprüche zur Abdeckung von optoelektronischen Bauelementen.

**Claims**

1. Siloxane-containing casting resin system which comprises a resin component A and at least one carboxylic acid anhydride as the curing component B, the A-component of which comprises
5 to 95 % by weight of epoxyalkylsiloxane and
95 to 5 % by weight of epoxide,
in which the epoxyalkylsiloxane has been obtained by reaction of the epoxyalkoxysilane (1) with the silanol (2)

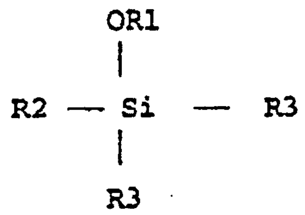

1

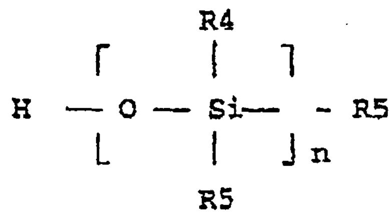

2

wherein

| | |
|---|---|
| R1 | is an alkyl radical having 1 to 6 C atoms or an aryl radical, |
| R2 | is an epoxyalkyl or an epoxycycloalkyl radical, the two radicals |
| R3 | independently of one another are OR1 or R2 or another alkyl or aryl radical, |
| R4 | is alkyl or aryl, the radicals |
| R5 | independently of one another are OH or R4 and |
| n | is an integer, where $1 \leq n \leq 12$. |

2. Casting resin system according to Claim 1, in which the B-component comprises anhydrides of aromatic and cycloaliphatic di- and tetracarboxylic acids.

3. Casting resin system according to Claim 1 or 2, in which the B-component comprises, for flexibilization, a carboxylic acid anhydride which is at least partly esterified with alcohols.

4. Process for the preparation of a siloxane-containing casting resin system comprising the following steps:

   a) reaction of the epoxyalkoxysilane 1 with the silanol 2, an epoxysiloxane being obtained,
   b) mixing of the epoxysiloxane with a cycloaliphatic or aromatic epoxide in a weight ratio of 1 : 20 to 20 : 1,
   c) provision of a B-component comprising a carboxylic acid anhydride.

5. Process according to Claim 4, in which step a) is carried out in the presence of a neutral condensation catalyst in the range of pH 5 to pH 8.

6. Process according to Claim 4 or 5, in which, after step b), the casting resin system is subjected to a heat treatment in vacuo.

7. Process according to one of Claims 4 to 6, in which the reaction according to step a) is carried out under stoichiometric conditions, so that one alkoxy group in 1 is available per OH group in 2 capable of condensation.

8. Process according to one of Claims 4 to 7, in which 3-glycidylpropyltrimethoxysilane as the alkoxysilane 1 and α, ω-propylphenylsilane diol as the silanol are reacted with one another.

9. Use of the casting resin system according to one of the preceding claims for covering optoelectronic components.

## Revendications

1. Système de résine à couler contenant du siloxane, qui comprend un constituant A de résine et au moins un anhydride d'acide carboxylique comme constituant B servant de durcisseur, dont le constituant A contient
de 5 à 95 % en poids d'époxyalcoylsiloxane et
de 95 à 5 % en poids d'époxyde,
dans lequel l'époxyalcoylsiloxane est obtenu par réaction de l'époxyalcoxysilane (1) sur le silanol (2)

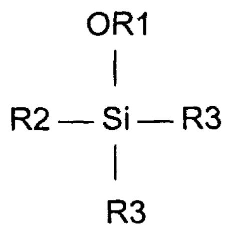

1

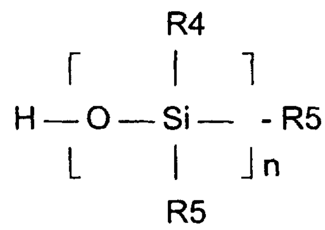

2

dans lequel
R1 représente un radical alcoyle ayant de 1 à 6 atomes de carbone ou un radical aryle,
R2 est un radical époxyalcoyle ou un radical époxycycloalcoyle, les deux radicaux
R3 représentent, indépendamment l'un de l'autre, OR1 ou R2 ou un autre radical alcoyle ou aryle,
R4 signifie alcoyle ou aryle, les radicaux
R5 représentant, indépendamment l'un de l'autre, OH ou R4, et
n est un nombre entier avec $1 \leq n \leq 12$.

2. Système de résine à couler suivant la revendication 1,
dans lequel le constituant B contient des anhydrides d'acide dicarboxylique et tétracarboxylique aromatiques et cycloaliphatiques.

3. Système de résine à couler suivant la revendication 1 ou 2,
dans lequel le constituant B contient, pour l'assouplissement, un anhydride d'acide carboxylique estérifié au moins en partie par des alcools.

4. Procédé de production d'un système de résine à couler contenant du siloxane ayant les stades suivants :

a) on fait réagir l'époxyalcoxysilane 1 sur le silanol 2 en obtenant un époxysilane ;
b) on mélange l'époxysiloxane à un époxy de cycloaliphatique ou aromatique en le rapport en poids de 1 : 1 à 20 : 1 ;
c) on prévoit un constituant B contenant un anhydride d'acide carboxylique.

5. Procédé suivant la revendication 4,
dans lequel on effectue le stade a) en présence d'un catalyseur neutre de condensation dans le domaine de pH de 5 à 8.

6. Procédé suivant la revendication 4 ou 5,
dans lequel on soumet le système de résine à couler après le stade b) à un traitement thermique sous vide.

7. Procédé suivant l'une des revendications 4 à 6,
dans lequel on effectue la réaction suivant le stade a) de manière stoechiométrique de manière à disposer par groupe OH susceptible d'être condensé en 2, d'un groupe alcoxy en 1.

8. Procédé suivant l'une des revendications 4 à 7,
dans lequel on fait réagir entre eux comme alcoxysilane 1 le 3-glycidylpropyltriméthoxysilane et comme silanol 2 l'α,ω-propylphénylsilandiol.

**9.** Utilisation du système de résine à couler suivant l'une des revendications précédentes pour revêtir des composants optoélectroniques.